Europäisches Patentamt

European Patent Office

Office européen des brevets

(11) Veröffentlichungsnummer: **0 413 848 A1**

(12) **EUROPÄISCHE PATENTANMELDUNG**

(21) Anmeldenummer: 89115715.8

(22) Anmeldetag: 25.08.89

(51) Int. Cl.5: **H01F 15/10, H01F 5/04**

(43) Veröffentlichungstag der Anmeldung:
27.02.91 Patentblatt 91/09

(84) Benannte Vertragsstaaten:
**AT BE CH DE ES FR GB GR IT LI LU NL SE**

(71) Anmelder: **Siemens Aktiengesellschaft
Wittelsbacherplatz 2
D-8000 München 2(DE)**

(72) Erfinder: **Meindl, Gerhard
Hartstrasse 22
D-8031 Alling(DE)**

(54) **Adapterplatte für elektrische Spulen.**

(57) Adapterplatte (1) für elektrische Spulen, geeignet zur Kontaktierung der in vorgegebenem Rastermaß angeordneten Spulen-Lötanschlußstifte mit einer Leiterplatte mit unterschiedlichem Rastermaß ihrer Leiterplattenbohrungen, wobei die Adapterplatte (1) voneinander elektrisch isolierte Leiterbahnen (2) trägt, deren Anzahl mindestens der Anzahl der Spulen-Lötanschlußstifte entspricht und die Leiterbahnen (2) so geführt und die Adapterplatte (1) in Teilabschnitten der Leiterbahnen (2) so durchbrochen sind, daß wahlweise unterschiedliche Rastermaße von Spulenkörperstiftanordnungen und Leiterplattenbohrungen einander angepaßt werden können.

## FIG 1

# ADAPTERPLATTE FÜR ELEKTRISCHE SPULEN

Die Erfindung betrifft eine Adapterplatte für elektrische Spulen, geeignet zur Kontaktierung der in vorgegebenem Rastermaß angeordneten Spulen-Lötanschlußstifte mit einer Leiterplatte mit unterschiedlichem Rastermaß ihrer Leiterplattenbohrungen.

Durch die europäische Patentschrift EP 0 212 609 ist eine elektrische Spule mit Spulenkörper mit Stirnflanschen mit Drahtführungsschlitzen, mit auf den Spulenkörper aufgeschobenen Schalenkernhälften mit Drahtführungsschlitzen und mit einem Anschlußträger für Leiterplatten mit Lötanschlüssen bekannt, auf den die Spule aufgesetzt und mit ihren Wickelenden mit den Lötanschlüssen elektrisch kontaktiert, insbesondere verlötet, verschweißt oder geklemmt ist.

Zur Ermöglichung einer weitgehend automatisierten Bewicklung und Montage der elektrischen Spule zeichnet sich diese durch folgende Merkmale aus:

Einer der Stirnflansche des Spulenkörpers ist als Stirnplatte ausgebildet, die Lötanschlüsse trägt und Durchbrechungen für die Seitenwandungen und den Mittelbutzen der einen Schalenkernhälfte aufweist,
der Anschlußträger ist durch eine auf diese Stirnplatte aufsetzbare Adapterplatte ersetzt, die auf ihrer Leiterplattenseite in vorgegebenem Rastermaß angeordnete Lötanschlüsse aufweist, die mit ihren hierzu abgekehrten Enden mit den Lötanschlüssen der Stirnplatte elektrisch kontaktiert, insbesondere verlötet, verschweißt oder geklemmt sind.

Durch den Ersatz des lötanschlußlosen Spulenkörperflansches durch eine Stirnplatte mit Lötanschlüssen ist die Voraussetzung für die gewünschte automatische Bewicklung der Spulenkörper geschaffen. Die wickelenden der Wicklung werden dabei vom Wickelautomaten unmittelbar an diese Lötanschlüsse angewickelt. Fehler in der Anschlußbelegung, wie sie bei Handbewicklung immer wieder auftreten, sind hier nicht mehr möglich.

Die hierbei verwendete Adapterplatte ist für eine große Anzahl von Stiftspulenkörpern unterschiedlichen Rastermaßes geeignet. Sie hat jedoch den Nachteil, daß sie stets nur auf ein bestimmtes Rastermaß der Leiterplatte festgelegt ist; also bei wechselndem Rastermaß der Leiterplatte eine neue Adapterplatte erforderlich ist. Die Folge dieses Nachteils ist eine erhebliche Verteuerung der Spulen und insbesondere ihrer Adapterplatten; zudem führt dies zu einer Vielzahl unterschiedlicher Teile und damit nicht nur zu hohen Entstehungs- sondern auch Lagerkosten.

Der vorliegenden Erfindung liegt die Aufgabe zugrunde, eine Adapterplatte zu schaffen, mittels der Stiftspulenkörper unterschiedlichster Stiftanordnung und insbesondere unterschiedlichsten Rastermaßes auf Leiterplatten beliebig vorgegebenen Rastermaßes aufsetzbar bzw. aufsteckbar sind.

Zur Lösung dieser Aufgabe sieht die Erfindung bei einer Adapterplatte der eingangs genannten Art vor, daß diese voneinander elektrisch isolierte Leiterbahnen trägt, deren Anzahl mindestens der Anzahl der Spulen-Lötanschlußstifte entspricht und daß die Leiterbahnen so geführt und die Adapterplatte in Teilabschnitten der Leiterbahnen so durchbrochen sind, daß wahlweise unterschiedliche Rastermaße von Spulenkörperstiftanordnungen und Leiterplattenbohrungen einander angepaßt werden können.

Zweckmäßigerweise sind die Leiterbahnen hinsichtlich ihrer Länge und Führung so bemessen, daß eine Vielzahl von Durchbrechungen je Leiterbahn und damit eine Vielzahl von Stiftanordnungen unterschiedlichsten Rastermaßes möglich ist. Ohne großen Aufwand lassen sich so Lötanschlußstifte in die dem jeweiligen Rastermaß der Leiterplatte entsprechenden Durchbrechungen der Adapterplatte einfügen. Bei gleicher Adapterplatte können folglich Spulen unterschiedlichsten Rastermaßes ihrer Lötanschlußstifte auf Leiterplatten aufgesetzt werden, die ihrerseits wiederum unterschiedlichste Rastermaße ihrer Leiterplattenbohrungen aufweisen können.

Die Erfindung wird nachstehend anhand eines Ausführungsbeispieles näher erläutert. Es zeigt:

FIG 1 eine Draufsicht auf eine Adapterplatte nach der Erfindung,

FIG 2 eine Seitenansicht der Adapterplatte nach FIG 1.

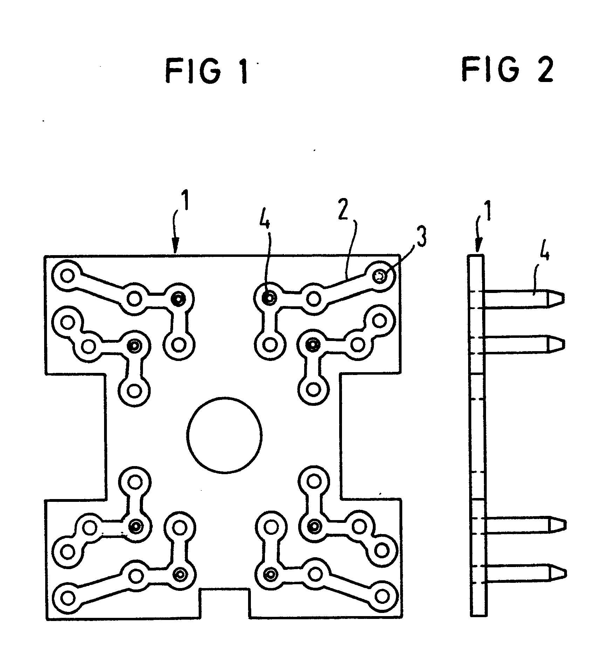

Eine in FIG 1, 2 mit 1 bezeichnete Adapterplatte aus Isolierstoff trägt auf ihrer einen Oberfläche Leiterbahnen 2. Diese Leiterbahnen sind so geführt und in Teilabschnitten so durchbrochen - siehe Durchbrechungen 3 - daß wahlweise unterschiedliche Rastermaße von Spulenkörperstifanordnungen und Leiterplattenbohrungen einander angepaßt werden können.

Je Rastermaß der Durchbohrungen einer in der Zeichnung nicht dargestellten Leiterplatte sind jeweils Lötanschlußstifte 4, mittels denen die Adapterplatte 1 auf die Leiterplatte aufgesteckt und aufgelötet wird - in die diesem Rastermaß entsprechenden Durchbrechungen 3 eingefügt, insbesondere eingedrückt. Die verbleibenden, nicht bestückten Durchbrechungen 3 sind dabei, und zwar je nach Rastermaß der nicht dargestellten Spulen-Lötanschlußstifte für die Aufnahme dieser Stifte bestimmt.

Die Leiterbahnen 2 weisen - betrachtet über ihre gesamte Länge -im wesentlichen gleiche Leiterbahnenbreite auf.

Die Adapterplatte ist bevorzugt in flacher Bauweise ausgeführt, wodurch eine größere Bauhöhenzunahme der Spule durch die Adapterplatte vermieden wird.

Die gemäß vorstehenden Ausführungen gestaltete Adapterplatte ermöglicht eine ausgezeichnete automatengerechte Zusammenfügung der einzelnen Komponenten der Spule. Die stifttragende Adapterplatte wird lediglich auf die fertiggewickelte Spule gesteckt, mittels Kleber, doppeltklebendes Band oder Klemmung dort fixiert und schließlich durch eine Tauchlötung mit den Spulen-Lötanschlußstiften elektrisch kontaktiert.

**Ansprüche**

1. Adapterplatte für elektrische Spulen, geeignet zur Kontaktierung der in vorgegebenem Rastermaß angeordneten Spulen-Lötanschlußstifte mit einer Leiterplatte mit unterschiedlichem Rastermaß ihrer Leiterplattenbohrungen, **dadurch gekennzeichnet,** daß die Adapterplatte (1) voneinander elektrisch isolierte Leiterbahnen (2) trägt, deren Anzahl mindestens der Anzahl der Spulen-Lötanschlußstifte entspricht und daß die Leiterbahnen (2) so geführt und die Adapterplatte (1) in Teilabschnitten der Leiterbahnen (2) so durchbrochen sind, daß wahlweise unterschiedliche Rastermaße von Spulenkörperstiftanordnungen und Leiterplattenbohrungen einander angepaßt werden können.

2. Adapterplatte nach Anspruch 1, **dadurch gekennzeichnet,** daß die Leiterbahnen (2) - betrachtet über ihre gesamte Länge - gleiche Leiterbahnbreite aufweisen.

3. Adapterplatte nach Anspruch 1, **dadurch gekennzeichnet,** daß die Adapterplatte (1) mittels Anschlußstiften (4) auf die Leiterplatte aufsteckbar ist, die in einem dem Rastermaß der Leiterplattenbohrungen entsprechenden Rastermaß in den Durchbrechungen (3) der Adapterplatte (1) gehalten sind.

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3384865 (BOSWORTH)<br>* Spalte 1, Zeilen 21 - 42 *<br>* Spalte 2, Zeile 60 - Spalte 3, Zeile 4; Figur 2 *<br>--- | 1. | H01F15/10<br>H01F5/04 |
| A | US-A-4766406 (KURGAN)<br>* Spalte 3, Zeilen 18 - 46; Figur 1 *<br>--- | 1. | |
| D,A | EP-A-0212609 (MEINDL)<br>----- | | |
| | | | **RECHERCHIERTE SACHGEBIETE (Int. Cl.5)**<br><br>H01F<br>H05K<br>H01R |

Der vorliegende Recherchenbericht wurde für alle Patentansprüche erstellt

| Recherchenort | Abschlußdatum der Recherche | Prüfer |
|---|---|---|
| DEN HAAG | 23 APRIL 1990 | BIJN E.A. |